(19) Europäisches Patentamt
European Patent Office
Office européen des brevets

(11) EP 0 824 603 B1

(12) FASCICULE DE BREVET EUROPEEN

(45) Date de publication et mention
de la délivrance du brevet:
30.06.1999  Bulletin 1999/26

(51) Int Cl.⁶: **C23C 14/24**, C23C 14/50,
H01J 9/02

(21) Numéro de dépôt: 96915075.4

(22) Date de dépôt: 23.04.1996

(86) Numéro de dépôt international:
PCT/FR96/00616

(87) Numéro de publication internationale:
WO 96/34123 (31.10.1996 Gazette 1996/48)

(54) **DISPOSITIF POUR DEPOSER UN MATERIAU PAR EVAPORATION SUR DES SUBSTRATS DE GRANDE SURFACE**

VORRICHTUNG ZUM MATERIALBESCHICHTEN GROSSFLÄCHIGER SUBSTRATE

DEVICE FOR VAPOUR-DEPOSITING A MATERIAL ON HIGH SURFACE AREA SUBSTRATES

(84) Etats contractants désignés:
DE GB IT

(30) Priorité: 24.04.1995  FR 9504873

(43) Date de publication de la demande:
25.02.1998  Bulletin 1998/09

(73) Titulaire: COMMISSARIAT A L'ENERGIE
ATOMIQUE
75015 Paris (FR)

(72) Inventeurs:
• IDA, Michel
  F-38340 Voreppe (FR)
• PERRIN, Aimé
  F-38330 Saint-Ismier (FR)
• BOREL, Michel
  F-38660 Le Touvet (FR)
• CHARLES, Raymond
  F-38430 Saint-Jean-de-Moirans (FR)

(74) Mandataire: Dubois-Chabert, Guy et al
c/o BREVATOME
25, rue de Ponthieu
75008 Paris (FR)

(56) Documents cités:
EP-A- 0 471 144          EP-A- 0 564 028
FR-A- 2 701 601          US-A- 5 334 302

• PATENT ABSTRACTS OF JAPAN vol. 015, no. 345 (C-0864), 3 Septembre 1991 & JP,A,03 134164 (RICOH CO LTD), 7 Juin 1991,
• PATENT ABSTRACTS OF JAPAN vol. 017, no. 093 (C-1029), 24 Février 1993 & JP,A,04 285157 (HITACHI LTD), 9 Octobre 1992,
• PATENT ABSTRACTS OF JAPAN vol. 013, no. 414 (C-635), 13 Septembre 1989 & JP,A,01 152265 (HITACHI LTD), 14 Juin 1989,

## Description

### Domaine technique auquel se rapporte l'invention

La présente invention se rapporte d'une manière générale au dépôt de matériau par évaporation sur un substrat de grande taille. Une application est la réalisation de sources d'électrons à micropointes utilisant l'émission électronique par effet de champ, lesdites sources étant de grande taille.

Ces sources d'électrons sont, par exemple, utilisées dans les dispositifs de visualisation par cathodoluminescence excitée par émission de champ, et en particulier dans les écrans plats de grande taille (de l'ordre du mètre carré).

### Etat de la technique

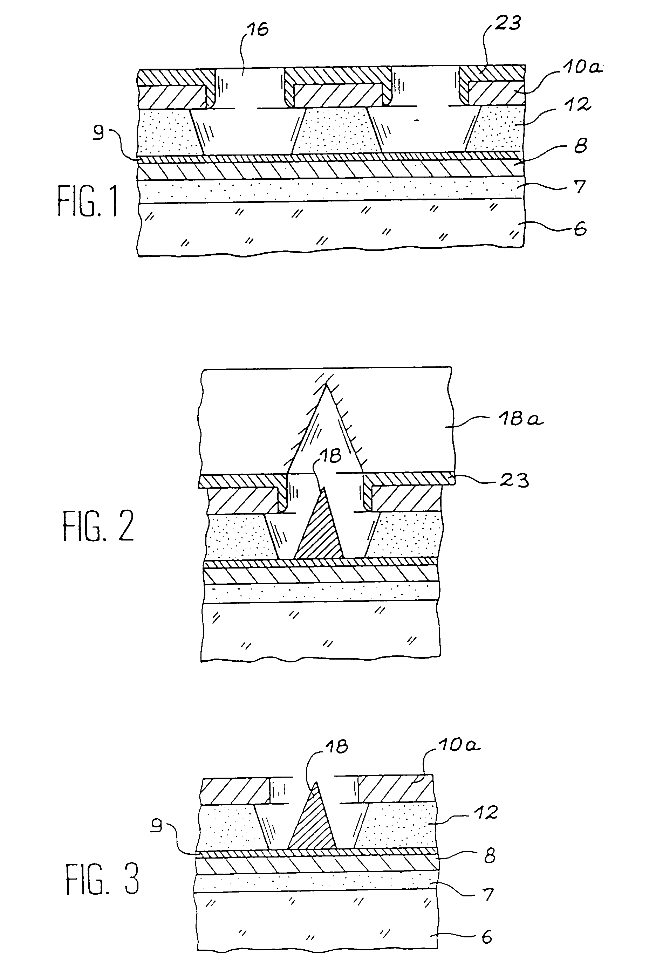

Un système émissif à micropointes et son procédé de fabrication sont décrits en détail par exemple dans le document FR-A-2 593 953 du 24/01/1986 ou dans le document FR-A-2 663 462 du 13/06/1990. On commencera d'abord par rappeler la technique connue de fabrication de telles micropointes dans une structure de ce genre, telle qu'elle ressort du document précité en se référant aux figures 1, 2 et 3 ci-jointes.

La figure 1 montre une structure déjà élaborée, comprenant sur un substrat 6 surmonté d'un isolant 7, un système de conducteurs cathodiques 8, une couche résistive 9, des grilles 10a superposées sous forme croisée avec un isolant intermédiaire 12 et une couche 23, par exemple de nickel, déposée en surface pour servir de masque lors des opérations de réalisation des micropointes. Cette couche 23 de nickel, les grilles 10a et l'isolant 12 sont percés de trous 16, dans le fond desquels il s'agit de venir déposer les futures micropointes constituées d'un métal conducteur en liaison électrique avec l'électrode cathodique 8 à travers la couche résistive 9.

Pour la réalisation des micropointes, on s'y prend de la façon suivante, en se référant à la figure 2. On commence d'abord par effectuer par exemple le dépôt d'une couche en molybdène 18a sur l'ensemble de la structure. Cette couche 18a présente une épaisseur environ de 1,8 μm. Elle est déposée sous incidence normale par rapport à la surface de la structure ; cette technique de dépôt permet d'obtenir des cônes 18 en molybdène logés dans les trous 16 ayant une hauteur de 1,2 à 1,5 μm. On réalise ensuite la dissolution sélective de la couche de nickel 23 par un procédé électrochimique de façon à dégager, comme représenté sur la figure 3, les grilles par exemple en niobium 10a perforées et à faire apparaître les micropointes 18 émettrices d'électrons.

A quelques variantes technologiques près, la méthode connue ainsi décrite en se référant aux figures 1, 2 et 3 est toujours celle que l'on applique jusqu'à ce jour pour réaliser les micropointes des systèmes à cathode émissive.

L'étape de dépôt de la couche en molybdène 18a est réalisée classiquement par évaporation de molybdène chauffé dans un creuset et condensation de la vapeur de molybdène sur le substrat recouvert de la structure empilée 7, 8, 9, 12, 10a et 23, percée de trous 16.

Pour obtenir des pointes 18 dans les trous 16, la vapeur doit arriver en incidence quasi-normale sur la surface de la structure précédemment décrite, par exemple sous un angle compris entre $\theta=0$ (incidence normale) et $\theta_{max}=9°$. Dans le cas contraire, le matériau évaporé risque de couvrir les parois des trous 16 et de créer des courts-circuits entre les électrodes 10a et les couches 8 et 9, ou bien il risque de remplir les trous sans créer de pointes.

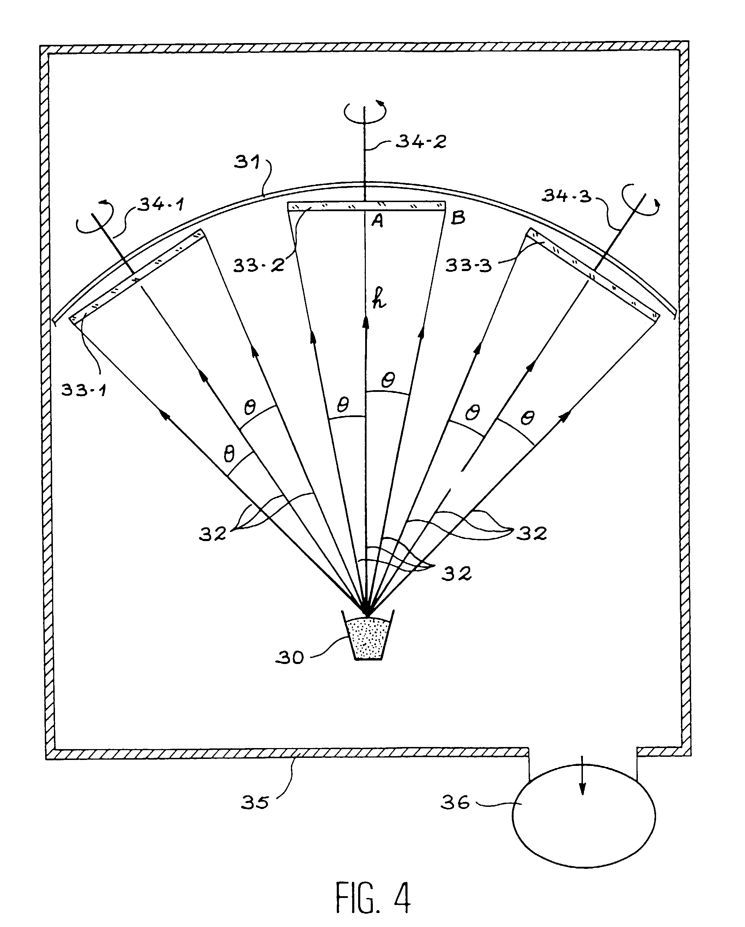

Un évaporateur classique est illustré sur la figure 4. Le matériau à évaporer est chauffé dans un creuset source 30. Les substrats 33-1, 33-2, 33-3 sont positionnés sur un porte-substrats 31 et entraînés en rotation sur eux-mêmes, autour d'un axe 34-1, 34-2, 34-3. Le porte-substrats 31 est placé en face du creuset 30 et il est lui-même en rotation autour de l'axe 34-2. L'évaporation se fait sous vide aux alentours de $10^{-5}$-$10^{-6}$ mbar dans une enceinte 35 pompée par un système de pompage adapté 36.

Dans le cas du dépôt de micropointes, le porte-substrats 31 a une forme adaptée pour que les substrats 33 reçoivent la vapeur en incidence quasi-normale avec un angle maximum $\theta_{max}$.

Ce dispositif convient bien pour effectuer des dépôts sur des substrats de taille petite ou moyenne (au maximum quelques dizaines de cm).

Des problèmes apparaissent quant on augmente la taille des substrats.

Ainsi, si on considère le cas de la figure 4, où le substrat 33-2 est placé en face de la source 30, à une distance h, on a alors $h = \frac{\overline{AB}}{tg\theta}$, $\overline{AB}$ étant le rayon (ou la demi-diagonale) du substrat. Pour un substrat d'un mètre de diagonale et un angle $\theta_{max}$ de 9° (incidence quasi-normale), la hauteur h est donc égale à $\frac{0.5}{tg9°} \simeq 3,16$ mètres. L'homme de l'art sait d'autre part que la vitesse d'évaporation sous vide est proportionnelle à $1/h^2$. Il y a donc tout intérêt à réduire la distance h entre la source et le substrat, et une distance de 3,16 m est inacceptable pour conserver une vitesse de dépôt importante.

En résumé, l'angle d'incidence de la vapeur : $\theta$ étant très petit (quelques degrés), il est quasiment impossible d'envisager le dépôt sur un substrat d'un mètre de diagonale, la vitesse de dépôt étant beaucoup trop faible pour un procédé industriel.

Le document FR-2 701 601 décrit un premier dispositif pour réaliser des sources à micropointes, encore appelé "appareil ICB". Un creuset est chauffé par un élément de chauffage et la matière vaporisée est ensuite partiellement ionisée, ce qui conduit à la formation d'amas qui sont accélérés.

Ce type de dispositif n'est pas adapté à la réalisation de dépôts sur des substrats de grande surface.

Un second dispositif est également décrit dans ce document, et comporte un creuset muni d'une pluralité de buses à travers lesquelles une vapeur est déchargée dans un caisson à vide, dans lequel elle est ionisée puis accélérée. Pour améliorer la directivité, ce document propose d'accroître le rapport $\frac{L}{r}$ où L est l'épaisseur du creuset et r le diamètre des buses.

Cependant, ce type de dispositif est incompatible avec une production industrielle, notamment sur des substrats de grande taille. En particulier, les buses peuvent être progressivement bouchées par des dépôts parasites de matière. Si le rapport $\frac{L}{r}$ est accru, afin d'accroître la directivité, ce problème devient encore plus aigu, puisque les vapeurs traversent les buses sur une longueur plus importante, tandis que ces dernières ont un diamètre plus faible. Il en résulte, en outre, des variations de débit de la matière évaporée.

Enfin, les dispositifs décrit dans ce documents mettent en oeuvre des sections d'ionisation et d'accélération, et sont donc complexes.

Exposé de l'invention

L'invention a pour objet de résoudre le problème ci-dessus, c'est-à-dire de proposer un dispositif simple, permettant d'effectuer des dépôts sur des substrats de grande surface, et permettant de conserver un angle d'incidence de la vapeur relativement petit et une vitesse de dépôt suffisante pour un procédé industriel.

A cette fin, l'invention a pour objet un dispositif pour déposer un matériau par évaporation sur un substrat, ce dispositif étant caractérisé en ce qu'il comprend :

- une enceinte dans laquelle sont placées des sources d'évaporation, en nombre n, du matériau à déposer par évaporation,
- des moyens pour canaliser les vapeurs émises par lesdites sources vers le substrat.

L'utilisation de plusieurs sources permet de diminuer la distance entre la source d'évaporation et le substrat, donc la hauteur du système. En outre, les moyens pour canaliser, vers le substrat, les vapeurs émises par les sources permettent de limiter l'angle d'incidence de la vapeur qui vient se condenser sur le substrat. Ainsi, on peut simultanément diminuer la distance source-substrat et l'angle d'incidence de la vapeur.

Les sources sont placées directement en regard du substrat : elles voient directement le substrat ou une portion de celui-ci.

Les moyens pour canaliser les vapeurs émises peuvent être des caches ou parois séparant les sources les unes des autres. Les caches forment des compartiments à l'intérieur de l'enceinte, chaque source d'évaporation étant disposée dans un compartiment. Ces caches ou parois peuvent être verticaux.

Selon une variante, les caches ou parois peuvent former des cellules ayant, au moins en partie, une forme tronconique.

Dans tous les cas, un porte-substrat permet de monter un substrat à proximité d'une des extrémités des parois.

Dans le cadre de la présente invention, un sous-problème consiste à améliorer l'uniformité du dépôt sur le substrat. Ces problèmes d'uniformité peuvent notamment apparaître du fait des moyens de canalisation des vapeurs. En particulier, lorsque ces moyens ont la forme de caches ou de parois, des marques définissant des zones masquées par ces moyens peuvent apparaître sur le substrat. La non-uniformité peut également être due à des vitesses de dépôt variable d'un point à un autre du substrat.

Afin de résoudre ce sous-problème, un dispositif selon la présente invention comporte en outre des moyens de mise en mouvement du substrat, de façon à faire passer différentes parties du substrat successivement devant les différentes sources.

Ces moyens peuvent être des moyens pour engendrer et/ou combiner des mouvements de rotation et/ou de translation dans un plan.

En particulier, le mouvement peut être un mouvement de rotation planétaire du substrat. Un mouvement de rotation planétaire du substrat sur lui-même et autour d'un axe appelé axe central du système d'évaporation, permet d'atteindre une très bonne uniformité.

Un mouvement combiné de rotation et de translation autour d'un axe, appelé axe central du système d'évaporation, permet de limiter avantageusement les dimensions latérales du système d'évaporation. En effet, dans ce cas, la surface totale décrite par le substrat est minimisée.

Un tel mouvement peut être assuré par un système à deux engrenages imbriqués tournant dans un même plan et autour d'une roue dentée fixe.

Selon une variante, le mouvement est assuré par un engrenage maintenu à distance constante d'une roue dentée fixe, une courroie dentée ou une chaîne entourant la roue dentée fixe et l'engrenage.

Selon un autre aspect de l'invention, les moyens pour canaliser les vapeurs émises par chaque source définissent, avec cette source, une cellule, la surface balayée par le substrat en mouvement dans cette cellule présentant, dans un plan perpendiculaire à la direction d'évaporation dans cette cellule, un centre de symétrie, la source étant placée sur un axe perpendiculaire à la surface balayée par le substrat et passant par ce centre de symétrie.

L'invention concerne également un procédé pour déposer un matériau par évaporation sur un substrat, caractérisé en ce qu'il comprend :

- l'introduction du substrat dans une enceinte d'un dispositif tel qu'il a été décrit ci-dessus.
- une étape d'évaporation du matériau à déposer sur le substrat.

Les problèmes résolus par ce procédé et les avantages qu'ils présentent correspondent aux problèmes et aux avantages déjà décrits ci-dessus en relation avec le dispositif.

Avantageusement, le substrat est un substrat d'un système émissif à micropointes, les micropointes étant réalisées par l'étape d'évaporation.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- les figures 1 à 3 illustrent différentes étapes de formation de micropointes, selon un procédé connu de l'art antérieur,
- la figure 4 est un dispositif d'évaporation selon l'art antérieur,
- les figures 5A et 5B représentent un mode de réalisation de l'invention,
- les figures 6A à 6C représentent différentes formes possibles pour une enceinte d'un dispositif conforme à la présente invention,
- la figure 7 représente schématiquement une source d'évaporation ponctuelle et un substrat,
- les figures 8A à 8E illustrent d'autres modes de réalisation de l'invention,
- les figures 9 à 20 sont des graphiques représentant l'uniformité d'un dépôt en différents points d'un substrat, pour des conditions et des indices d'émission variables.

Exposé détaillé de modes de réalisation de l'invention

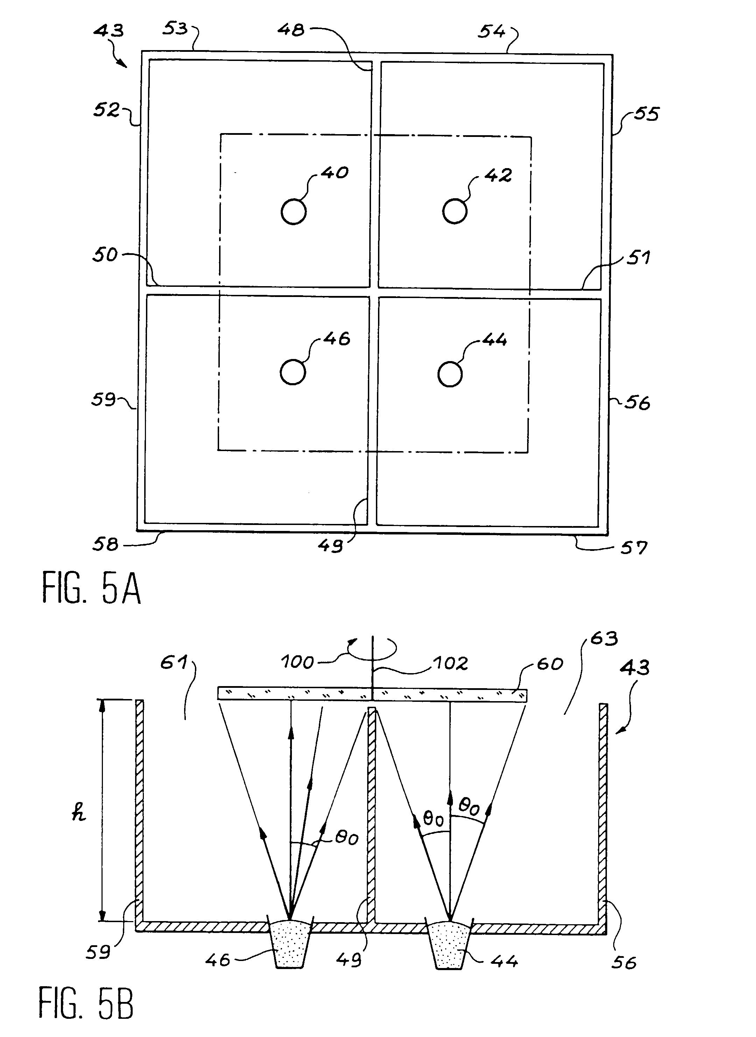

Un premier exemple d'un mode de réalisation de l'invention va être décrit en liaison avec les figures 5A et 5B, qui représentent respectivement une vue de dessus et une vue en coupe d'un dispositif conforme à l'invention.

Ce dispositif consiste essentiellement en une enceinte 43 qui présente, dans l'exemple illustré sur les figures, une section approximativement carrée. Cette enceinte est délimitée par des parois 52, 53, ..., 59. Cette enceinte est divisée en quatre compartiments par des parois 48, 49, 50, 51. Au fond de chacun de ces compartiments se trouve une source d'évaporation 40, 42, 44, 46. Une surface ou substrat 60 peut être introduit dans le haut de l'enceinte 43, et monté sur un porte-substrat (non représenté sur la figure) de manière à ce que la surface de dépôt se situe à une distance h du fond de l'enceinte 43. La présence des différentes parois verticales permet d'éviter que de la matière ne soit évaporée sur la surface du substrat avec un angle supérieur à l'angle $\theta_0$ représenté sur la figure 5B. Il est donc possible de réaliser un dépôt avec une valeur de l'angle d'évaporation $\theta_0$ inférieur ou égal à $\theta_{max}$ donné, et avec une distance h que l'on peut choisir de façon à peu près quelconque, simplement en choisissant au départ la hauteur des parois 48, 49, 50, 51 et la disposition de ces dernières à l'intérieur de l'enceinte 43, leur disposition délimitant des surfaces plus ou moins grandes du substrat 60.

L'exemple ci-dessus est limité à quatre sources d'évaporation. Il est également possible de réaliser une enceinte 43 comportant deux, trois, cinq ou plus de cinq sources d'évaporation, suivant les besoins. Par ailleurs, l'enceinte 43 est équipée d'un dispositif de pompage (non représenté sur les figures) permettant d'assurer un certain vide lors de l'opération d'évaporation.

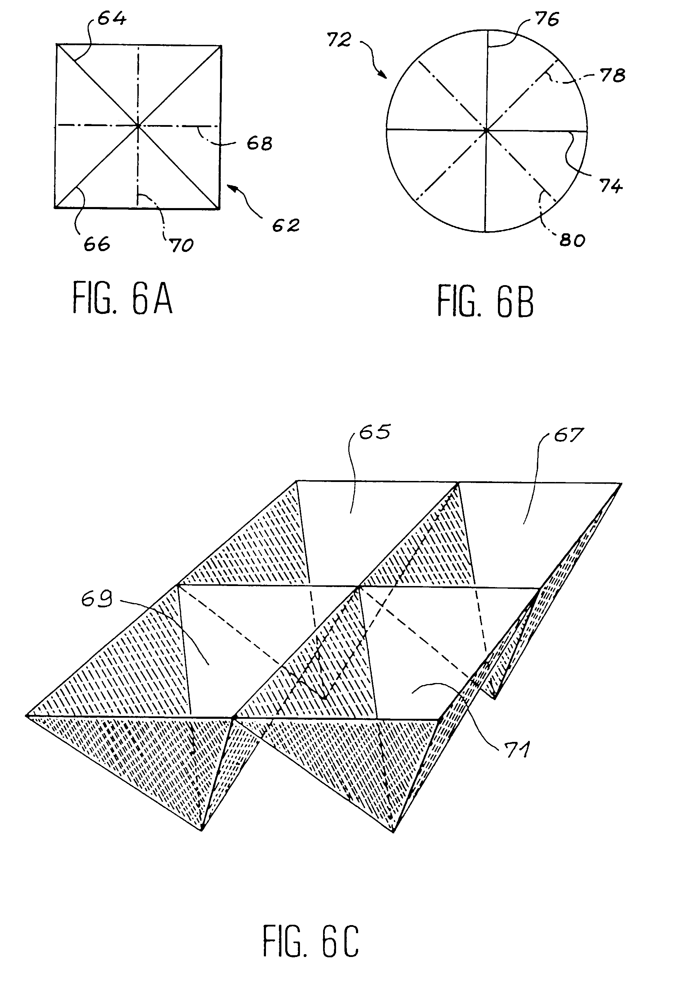

L'enceinte qui a été décrite présente des parois verticales, disposées perpendiculairement entre elles et définissant les compartiments approximativement cubiques. Il est clair que les dimensions des différentes parois peuvent être modifiées, ainsi que la répartition des compartiments à l'intérieur d'un même volume d'une enceinte. Ainsi, on a représenté sur les figures 6A, 6B, 6C différentes formes possibles d'enceintes et différentes répartitions possibles des parois à l'intérieur de l'enceinte.

La figure 6A est une vue de dessus d'une enceinte 62 ayant une forme extérieure sensiblement identique à celle de l'enceinte 43 des figures 5A et 5B. A l'intérieur, des parois 64, 66 sont disposées en diagonale, une source d'évaporation étant disposée au fond de chacun des quatre compartiments ainsi délimités. Huit compartiments peuvent être réalisés en introduisant des parois 68, 70 supplémentaires, et quatre sources d'évaporation supplémentaires. Le dispositif de la figure 6B comporte une enceinte ayant globalement la forme d'un cylindre 72 et un certain nombre de parois 74, 76, 78, 80 délimitant des secteurs cylindriques à l'intérieur de l'enceinte 72. Une source d'évaporation est disposée au fond de chaque secteur cylindrique.

La figure 6C représente une enceinte à l'intérieur de laquelle des compartiments 82, 84, 86, 88 de forme tronconique sont réalisés, les différentes parois à l'intérieur de l'enceinte n'étant plus disposées de manière verticale comme dans les exemples précédents.

D'une façon plus générale, les parois délimitant des compartiments à l'intérieur de l'enceinte peuvent former des cellules présentant une symétrie cylindrique à base polygonale (c'est le cas des figures 5A, 6A, 6B) ou bien des cellules présentant une forme partiellement tronconique.

Dans tous les cas, la présence de parois à l'intérieur de l'enceinte permet de conserver la directivité de la vapeur sur toute la surface du substrat tout en minimisant la distance entre la source d'évaporation et le substrat. Ceci a pour conséquence de conserver une vitesse de dépôt raisonnable et donc de minimiser le temps nécessaire pour réaliser le dépôt.

Les parois, ou caches, définissent dans tous les cas des compartiments à l'intérieur de l'enceinte. Chaque source se situe à l'intérieur d'un compartiment. Chaque compartiment présente une ouverture 61, 63 (figure 5B), 65, 67, 69, 71 (figure 6C) à proximité de laquelle se situe le substrat. En fait, c'est un porte-substrat qui permet de positionner le substrat à proximité des ouvertures. On peut également dire que le substrat se situe à proximité d'une extrémité des parois.

La présence de parois ou de caches peut conduire à un dépôt qui, bien que réalisé à vitesse satisfaisante, présente des défauts d'uniformité sur le substrat.

Par ailleurs, l'uniformité peut être due à des écarts de vitesse de dépôt entre différents points d'un même substrat. Pour certains procédés industriels, cet écart de vitesse de dépôt peut être un réel problème puisque le temps de dépôt total sera conditionné par le temps nécessaire pour couvrir les zones où la vitesse de dépôt est la plus faible. Ceci a pour conséquence l'augmentation du temps de fabrication et le gaspillage de beaucoup de matériau évaporé. Ce dernier se trouve alors en surépaisseur dans les zones de forte vitesse de dépôt et sur les parois du système d'évaporation.

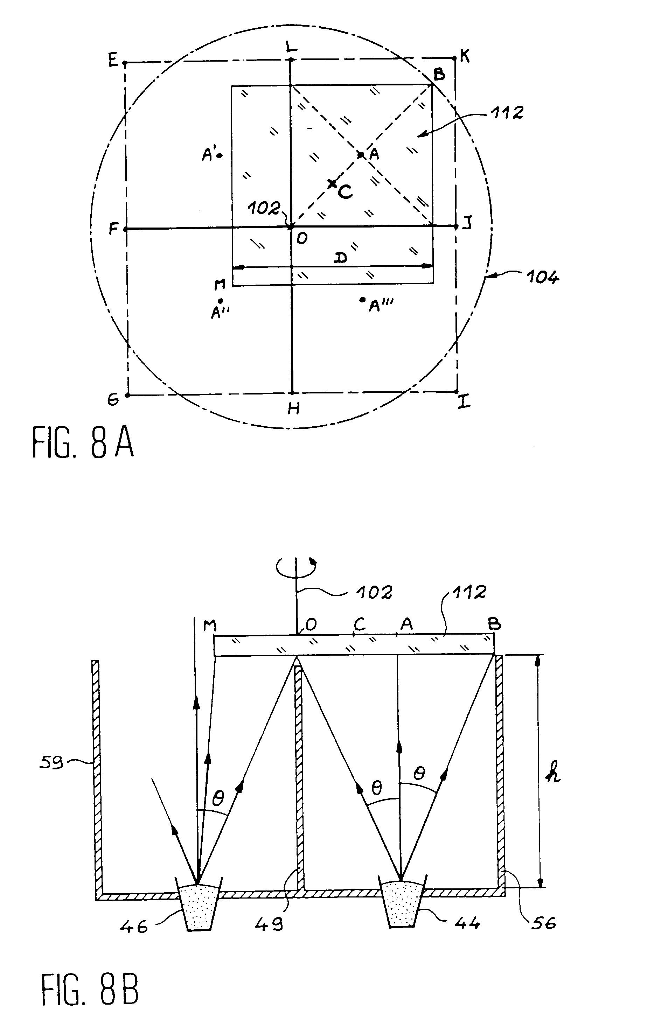

Il est possible de donner une valeur quantitative de l'uniformité, d'un point à l'autre de la surface sur laquelle on réalise le dépôt, en comparant les vitesses de dépôt entre ces deux points. Par exemple, dans la géométrie illustrée sur la figure 7, on peut considérer une source d'évaporation approximativement ponctuelle disposée en un point P, à une distance h d'un substrat 90. Soit $E_1$ le point du substrat le plus proche de la source P, et $E_2$ un point de la surface située à une distance d de la source. $\beta$ désigne l'angle compris entre la droite $PE_2$ et la normale au substrat 90, au point $E_2$.

La loi mathématique d'émission de vapeur au-dessus de la source peut s'écrire sous la forme d'un développement limité en $\cos^n\theta$ (connu de l'homme de l'art). En pratique, on limite ce développement à un certain nombre de termes en fonction de la nature de la source et de la charge (la charge étant le matériau à évaporer placé dans le creuset source d'évaporation). Pour une évaporation normale avec un matériau qui ne "creuse" pas trop, l'homme de l'art considère que l'on peut se limiter à un indice d'émission n=4. Dans les calculs il est possible de faire varier n de 1 à 7 pour balayer tous les cas.

Pour calculer le rapport des vitesses $V_2/V_1$, respectivement aux points $E_2$ et $E_1$, on sait que, dans l'axe, la vitesse décroît avec le carré de la distance. Donc :

$$V_1 = \frac{V_0}{h^2},$$

$V_0$ étant la vitesse au niveau de la source P et :

$$V_2 = \frac{V_0 \cos^n\theta \cos\beta}{d^2}.$$

Comme $\beta=\theta$ :

$$V_2 = \frac{V_0 \cos^n\theta \cos\theta}{d^2}.$$

Par conséquent :

$$\frac{V_2}{V_1} = h^2 \quad \frac{Cos^n\theta\cos\theta}{d^2} = \cos^n\theta\cos\theta\cos^2\theta = \cos^{n+3}\theta$$

L'uniformité varie donc comme le $\cos^{n+3}\theta$ de l'angle $\theta$ d'évaporation.

Par conséquent, même pour une charge d'évaporation correspondant à n=1, l'uniformité variera en $\cos^4\theta$.

Ceci montre que (à distance source-substrat fixe) dès que l'on augmente $\theta$, les conséquences sont très grandes sur l'uniformité. Les variations correspondantes du temps de dépôt et de la quantité de matériau évaporé gaspillé peuvent être considérables.

Afin de résoudre ce problème de non-uniformité, il est possible d'améliorer l'invention en incorporant un dispositif permettant de donner un mouvement de rotation et/ou de translation au substrat ou plutôt au porte-substrat sur lequel est monté le substrat. En particulier, ce mouvement sera réalisé dans le plan défini par le substrat lui-même.

Ce mouvement permet d'améliorer l'uniformité de dépôt tout en limitant les dimensions latérales du système. Il permet d'autre part d'éviter qu'il y ait des zones masquées par les caches sur le substrat.

Un exemple va être donné en liaison avec les figures 8A et 8B. Sur ces figures, le dispositif d'évaporation est identique à celui qui a été décrit sur les figures 5A et 5B. Par conséquent, des références numériques identiques y désigneront les mêmes éléments. Un substrat 112, de forme approximativement carrée, est disposé de manière dissymétrique par rapport aux différents compartiments.

Il est tout d'abord possible d'effectuer une double rotation du substrat sur lui-même et autour de l'axe 102 (rotation planétaire). Dans ce cas, la trajectoire la plus large décrite par un des coins du substrat est inscrite dans une trajectoire circulaire désignée sur la figure 8A par la référence 104. Il faut, dans ce cas, utiliser un système de dépôt sous vide dont les dimensions latérales permettent de réaliser des dépôts homogènes sur toute la surface limitée par la trajectoire circulaire 104.

Le mouvement planétaire du substrat est une combinaison d'un mouvement de rotation du substrat autour de l'axe central du système et d'un mouvement de rotation du substrat autour d'un axe perpendiculaire à son plan (passant par exemple par son centre de symétrie, si le substrat présente un tel centre de symétrie).

Un autre mouvement possible est un mouvement de rotation-translation sans rotation du substrat sur lui-même. A cette fin, le porte-substrat 99 est fixé sur un engrenage représenté sur la figure 8C par la référence 97 de façon que, par exemple, le centre du substrat C (figure 8A) coïncide avec le centre (axe) de cet engrenage. Une roue dentée fixe 96, de même diamètre que cet engrenage 97 et possédant le même nombre de dents et le même pas entre les dents est fixée sur l'axe 102 du système d'évaporation. Un deuxième engrenage 95, possédant le même pas entre les dents, relie l'engrenage de centre C à la roue dentée fixe de centre O.

Les deux engrenages 95 et 97 sont reliés à un bras support 98, par exemple, à l'aide de roulements à billes, afin d'assurer leur mobilité. Ce bras support 98 tourne autour de l'axe de la roue dentée fixe 96, l'entraînement 100 se fera par exemple à l'aide d'un moteur.

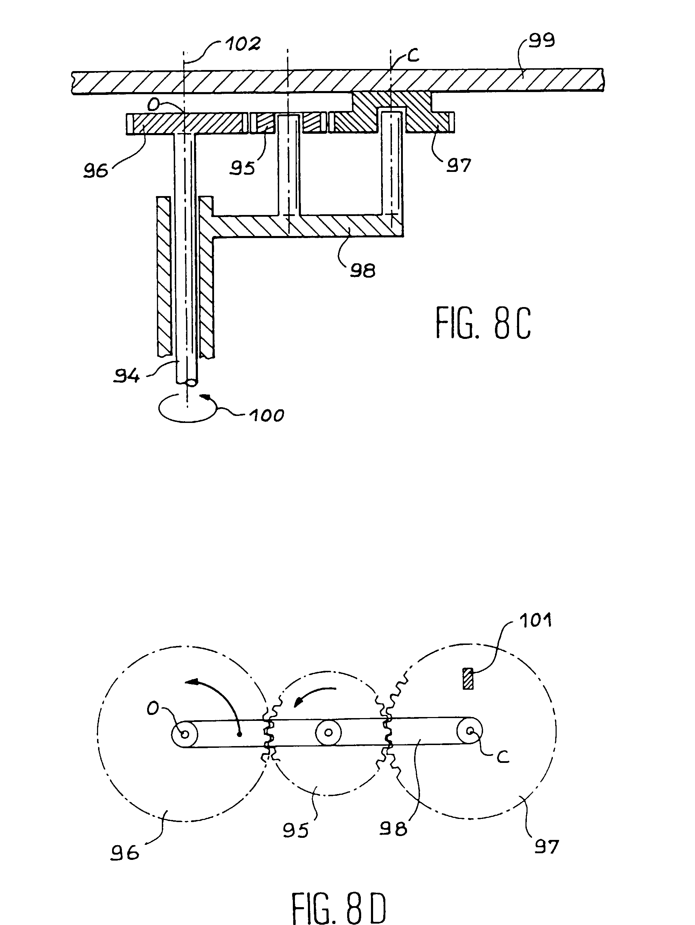

Les deux engrenages et la roue dentée fixe sont dans un même plan. Du fait de la rotation du bras 98, les engrenages 95 et 97 tournent autour de la roue dentée fixe. Un exemple de rotation est donné figure 8D, des flèches indiquent un sens possible de rotation.

Comme la roue 96 et l'engrenage 97 ont le même nombre de dents et le même pas et que l'engrenage 95 a le même pas, si l'on trace un repère 101 sur l'engrenage 97, ce repère se déplacera en restant toujours parallèle à lui-même.

Il y a donc une rotation du centre C autour du point O sans que la direction du repère 101 ne change.

On fixera le substrat 112 sur le porte-substrat 99 par exemple à l'aide de vis, et le porte-substrat 99 sur l'engrenage 97 (figure 8C).

Ce système permet donc d'entraîner en rotation-translation le substrat 112 autour du centre O du système d'évaporation.

Tout autre système mécanique est utilisable, qui permet d'obtenir le même mouvement ; par exemple comme illustré sur la figure 8E, il est possible de supprimer l'engrenage 95 des figures 8C et 8D et de le remplacer par une courroie dentée 105 qui entoure la roue dentée fixe 96 et l'engrenage 97.

Le mouvement résultant sera le même que celui déjà décrit ci-dessus (rotation-translation). On pourra dans un autre exemple remplacer la courroie dentée par une chaîne.

Sur la figure 8A, le carré (EGIK) à coins tronqués détermine l'espace dans lequel le substrat va évoluer dans le cas d'un mouvement de rotation-translation. Dans ce cas, il est clair que les dimensions latérales nécessaires du système d'évaporation ne sont pas aussi grandes que dans le cas où le substrat effectue un mouvement de rotation planétaire (le substrat évoluant alors dans le cercle 104).

Selon un autre aspect de l'invention, et dans le cas ou, dans une cellule, la surface balayée par le substrat en mouvement dans cette cellule, dans un plan perpendiculaire à la direction principale d'évaporation présente un centre de symétrie, on placera préférentiellement chaque source d'évaporation, dans chaque compartiment sur un axe perpendiculaire à la surface à revêtir et passant par ce centre de symétrie.

S'il n'y a pas de centre de symétrie, comme c'est le cas sur la figure 8A, on placera chaque source dans chaque compartiment à la moitié de la distance maximale OB correspondant au point du substrat 112 le plus éloigné du centre O.

En effet, si on déplace la source de cette position, il est nécessaire d'augmenter la valeur de la hauteur h pour conserver le même angle maximum $\theta_{max}$ sous lequel l'évaporation est réalisée sur le substrat.

Dans le cas du dispositif illustré sur les figures 8A et 8B, dans sa version avec système d'engrenage permettant d'effectuer un mouvement de rotation-translation du substrat, il est possible d'évaluer la valeur de h en fonction de la distance $\overline{OC}$, et de la taille du substrat (on supposera un substrat carré de côtés D, comme représenté sur la figure 8A). On a alors : $h = \frac{\overline{OA}}{tg\theta}$ ($\theta$ est l'angle maximum d'évaporation.

D'autre part, on peut calculer $\overline{OA}$ en fonction de la distance $\overline{OC}$ ; en effet :

$$\overline{OA} = \frac{\overline{OB}}{2}, \qquad \overline{OB} = \overline{MB} - \overline{MO} = D\sqrt{2} - \left(\frac{D\sqrt{2}}{2} - \overline{OC}\right)$$

$$\overline{OA} = \frac{D\sqrt{2}}{2} - \frac{D\sqrt{2}}{4} + \frac{\overline{OC}}{2} = \frac{D\sqrt{2} + 2\overline{OC}}{4}$$

On en déduit :

$$h = \frac{\overline{OA}}{tg\theta} = \frac{2\overline{OC} + D\sqrt{2}}{4tg\theta}$$

Si on prend, par exemple, un substrat de 1 m de diagonale, on a : $D\simeq0,7$ m. On choisit par exemple de limiter l'angle de la vapeur incidente à $\theta=15°$ et d'utiliser un système dont la distance $\overline{OC}$ entre la roue fixe 96 et l'engrenage extérieur 97 est de 0,1 mètre ; alors la hauteur d'un tel système sera :

$$h = \frac{2x0,1 + 0,7\sqrt{2}}{4tg15°} \simeq 1,11 \text{ mètres,}$$

pour un angle $\theta=9°$ on aura : $h\simeq1,88$ mètres.

Toujours dans le cas d'un substrat carré et d'un dispositif tel que décrit ci-dessus en liaison avec les figures 8A et 8B, l'uniformité du dépôt peut être calculée en faisant la somme des contributions des quatre sources d'évaporation sur le substrat. On calcule par exemple le rapport entre la vitesse moyenne de dépôt en un point et la vitesse moyenne de dépôt au centre du substrat carré.

Ce calcul a été fait pour différents points le long d'une demi-diagonale du substrat, en rotation-translation autour de l'axe 102, sans rotation sur lui-même (voir figures 8C et 8D), et pour un substrat de 1 mètre de diagonale.

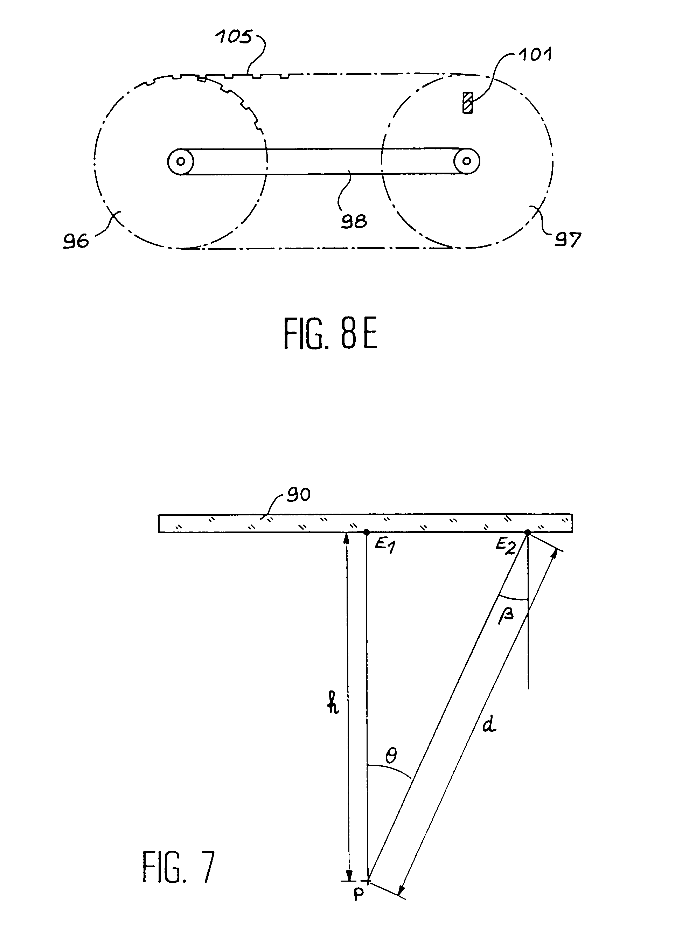

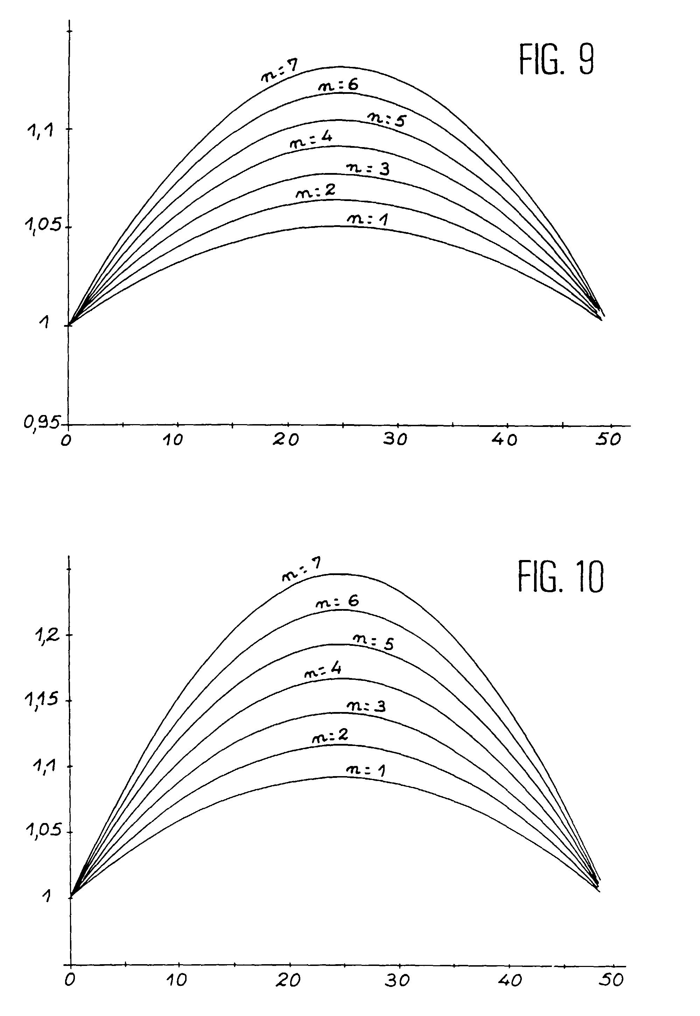

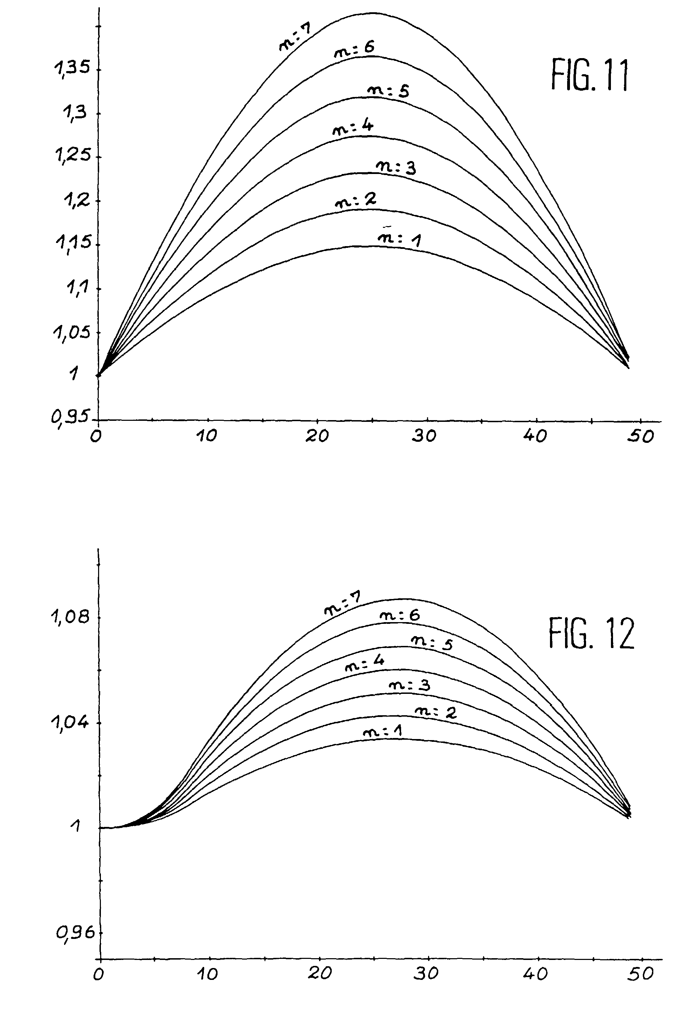

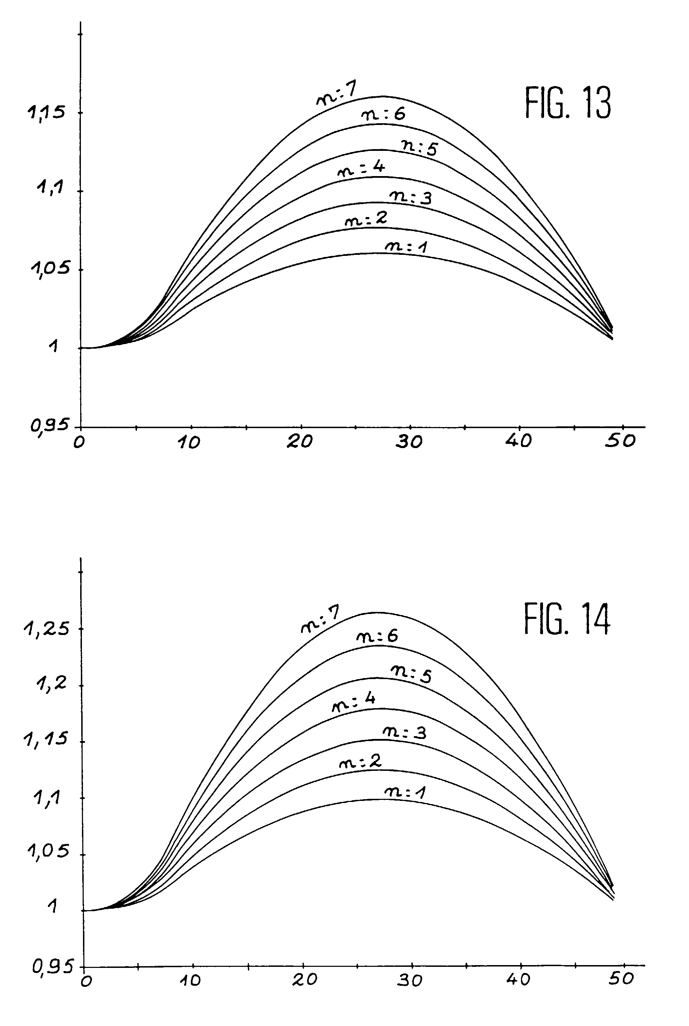

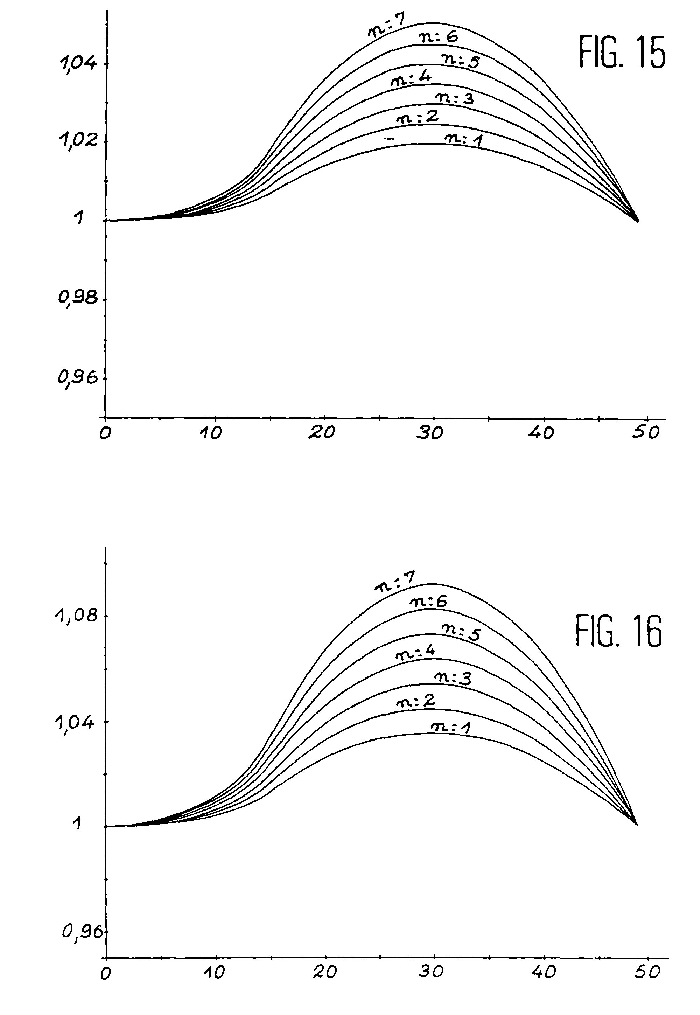

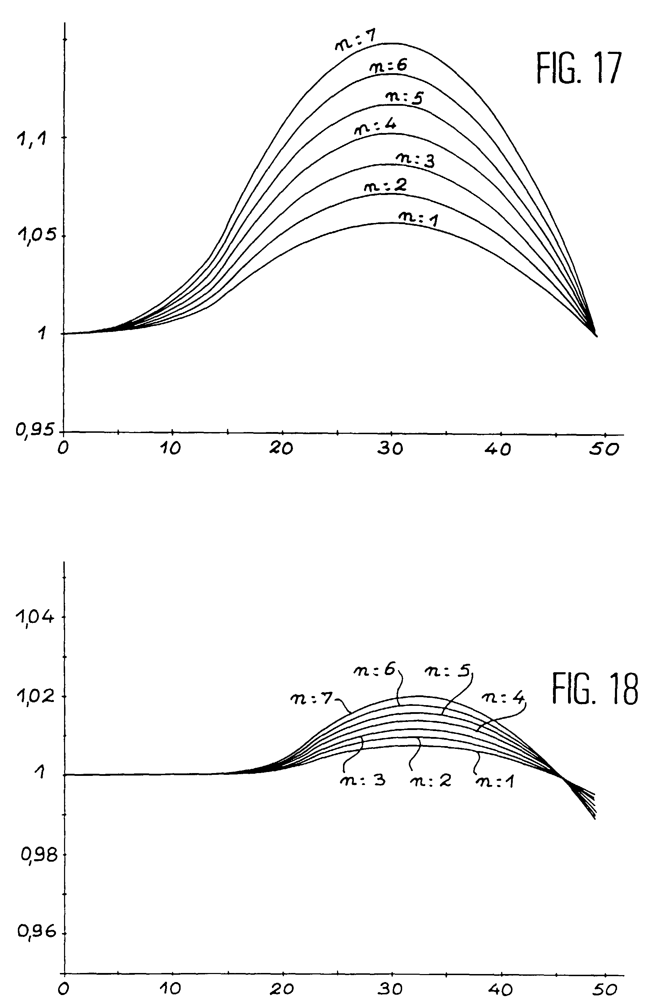

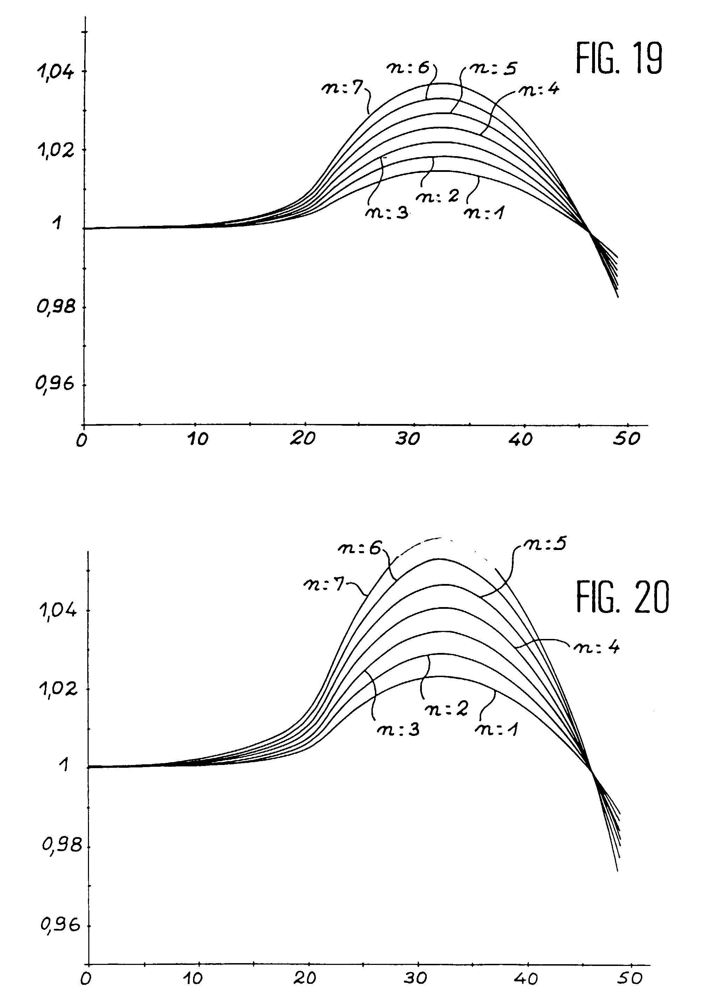

Les résultats des calculs sont donnés sur les figures 9 à 20. Sur chacune de ces figures, la graduation en abscisse va de 0cm (centre du substrat) à 50cm (coin du substrat). L'axe des ordonnées représente le rapport des vitesses de dépôt, la vitesse de référence étant la vitesse au centre du substrat.

Les courbes d'une même figure représentent l'uniformité d'épaisseur pour différentes valeurs de l'indice d'émission n de la source, comprises entre 1 et 7. Pour une évaporation "normale" (matériau qui ne creuse pas trop) la valeur de n à considérer est : n=4.

Les figures 9 à 11 correspondent à un substrat immobile et servent de référence pour comparaison.

Les différents paramètres géométriques (distance source-substrat, angle d'incidence maximum de la vapeur sur le substrat, distance OC) sont donnés, pour chaque figure, dans le tableau I ci-après.

TABLEAU I

| FIGURES | h (Cm) | θ (°) | OC (cm) | Uniformité n=4, % |
|---------|--------|-------|---------|-------------------|
| 9 | 157 | 9° | 0 | ±4,5 |
| 10 | 117 | 12° | 0 | ±8,5 |
| 11 | 92 | 15° | 0 | ±13,5 |
| 12 | 173 | 9° | 5 | ±3 |
| 13 | 129 | 12° | 5 | ±5,5 |
| 14 | 102 | 15° | 5 | ±9 |
| 15 | 188 | 9° | 10 | ±1,75 |
| 16 | 140 | 12° | 10 | ±3,1 |
| 17 | 111 | 15° | 10 | ±5 |
| 18 | 204 | 9° | 15 | ±0,75 |
| 19 | 145 | 12° | 15 | ±1,25 |
| 20 | 120 | 15° | 15 | ±2 |

La dernière colonne du tableau (uniformité, n=4) permet de comparer les résultats obtenus dans les différents cas, pour n=4. Il faut remarquer que dans tous les cas l'uniformité reste meilleure que ±9%, avec OC≥5cm. Cette uniformité s'améliore nettement lorsque OC augmente. En contrepartie, il faut augmenter la hauteur h du système et bien évidemment sa largeur.

Par ailleurs, dans tous les cas, la hauteur du système reste petite en comparaison avec les 3,16m du système de l'art antérieur (figure 4), valeur qui a été calculée dans l'introduction à la présente demande. La valeur de h varie de lm à 2m dans les exemples donnés, en fonction de la configuration (angle θ et distance OC). Cette gamme de hauteurs (1-2 mètres) est tout à fait acceptable par l'homme de l'art, la limitation se situant aux alentours de 2 mètres de hauteur. Il sera bien sûr préférable de diminuer au maximum cette hauteur, par exemple en acceptant une tolérance plus grande sur l'angle θ (par exemple jusqu'à 15°).

Dans tous les calculs ci-dessus, il a été considéré que les quatre sources sont parfaitement identiques. Dans le cas d'un mouvement de rotation-translation, cette condition permet d'obtenir de très bonnes uniformités. Dans le cas d'un mouvement planétaire (double rotation du substrat sur lui-même et autour de l'axe 102), cette condition joue un rôle moins important.

En ce qui concerne les uniformités observées ci-dessus, elles seraient encore améliorées dans le cas d'un mouvement planétaire. Mais ceci se ferait bien entendu au détriment de l'encombrement latéral du dispositif.

Toutes les applications où l'on veut réaliser des dépôts sur des grandes surfaces, ces dépôts nécessitant soit une bonne uniformité, soit un dépôt sous une incidence limitée, soit les deux, sont concernées par le présent dispositif.

En premier lieu, il est possible de réaliser des dépôts de micropointes pour réaliser des sources d'électrons, par exemple une source telle que celle décrite ci-dessus, en liaison avec les figures 1 à 3.

L'invention concerne donc également un procédé pour réaliser des dépôts sur des grandes surfaces, ce procédé consistant à introduire la surface, ou substrat, dans un dispositif tel qu'il a été décrit ci-dessus, conformément à l'invention. Dans le cas où l'on souhaite réaliser une source d'électrons à micropointes, par exemple pour les écrans plats, on introduit dans le dispositif d'évaporation un substrat ayant la structure décrite ci-dessus en liaison avec la figure 1.

D'autres applications sont envisageables, pour la réalisation de miroirs, pour des traitements optiques, ou mécaniques.

**Revendications**

1.   Dispositif pour déposer un matériau par évaporation sur un substrat (60, 90, 112), caractérisé en ce qu'il comprend :

-   une enceinte (43, 62, 72) dans laquelle sont placées des sources (40, 42, 44, 46) d'évaporation du matériau, en nombre n,
-   des moyens (48-51, 64, 66, 68, 70, 74, 76, 78, 80) pour canaliser les vapeurs émises par lesdites sources vers le substrat, lors de l'évaporation, formés par des parois, ou des caches, définissant des compartiments à l'intérieur de l'enceinte, chaque source d'évaporation étant disposée dans un compartiment.

2. Dispositif selon la revendication 1, les caches ou parois étant verticaux.

3. Dispositif selon la revendication 1, les caches ou parois formant des cellules ayant au moins en partie une structure tronconique.

4. Dispositif selon l'une des revendications 1 à 3, comprenant en outre des moyens (94-100) de mise en mouvement d'un substrat de façon à faire passer différentes parties du substrat successivement devant différentes sources.

5. Dispositif selon la revendication 4, les moyens de mise en mouvement étant des moyens pour engendrer et/ou combiner des mouvements de rotation et/ou de translation dans un plan.

6. Dispositif selon la revendication 5, le mouvement étant un mouvement de rotation planétaire du substrat sur lui-même.

7. Dispositif selon la revendication 5, le mouvement étant un mouvement de rotation-translation du substrat.

8. Dispositif selon la revendication 7, le mouvement étant assuré par un système à deux engrenages imbriqués (95, 97) tournant dans un même plan et autour d'une roue dentée fixe (96).

9. Dispositif selon la revendication 7, le mouvement étant assuré par un engrenage (97) maintenu à distance constante d'une roue dentée fixe (96), une courroie dentée (105) ou une chaîne entourant la roue dentée fixe (96) et l'engrenage (97).

10. Dispositif selon la revendication 4, les moyens pour canaliser les vapeurs émises par chaque source définissant, avec cette source, une cellule, la surface balayée par le substrat en mouvement dans cette cellule présentant, dans un plan perpendiculaire à la direction d'évaporation dans cette cellule, un centre de symétrie, la source étant placée sur un axe perpendiculaire à la surface balayée par le substrat et passant par ce centre de symétrie.

11. Procédé de dépôt par évaporation d'un matériau sur un substrat, caractérisé en ce qu'on introduit le substrat dans une enceinte d'un dispositif selon l'une des revendications 1 à 10, et en ce qu'on réalise ensuite l'évaporation.

12. Procédé selon la revendication 11, le substrat étant un substrat pour source d'électrons à micropointes.

**Patentansprüche**

1. Vorrichtung zum Materialbeschichten eines Substrats (60, 90, 112) durch Aufdampfen, **dadurch gekennzeichnet**, daß sie umfaßt:

   - einen Behälter (43, 62, 72), in dem sich die Verdampfungsquellen (40, 42, 44, 46) des Materials befinden, n an der Zahl,
   - Einrichtungen (48-51, 64, 66, 68, 70, 74, 76, 78, 80), um die von den genannten Quellen entwickelten Dämpfe während des Aufdampfens in Richtung Substrat zu kanalisieren, wobei diese Einrichtungen gebildet werden durch Wände oder Abteilungen, die im Innern des Behälters Abteile bilden, und jede Verdampfungsquelle in einem Abteil angeordnet ist.

2. Vorrichtung nach Anspruch 1, wobei die Abteilungen oder Wände senkrecht sind.

3. Vorrichtung nach Anspruch 1, wobei die Abteilungen oder Wände Zellen bilden, die wenigstens teilweise eine kegelstumpfartige Struktur haben.

4. Vorrichtung nach einem der Ansprüche 1 bis 3, wobei sie außerdem Einrichtungen (94-100) zum Bewegen eines Substrats umfaßt, sodaß verschiedene Teile des Substrats nacheinander an verschiedenen Quellen verbeigeführt werden.

5. Vorrichtung nach Anspruch 4, wobei die Bewegungseinrichtungen (94-100) Einrichtungen zum Erzeugen und/oder Kombinieren von Rotations- und/oder Translationsbewegungen in einer Ebene sind.

6. Vorrichtung nach Anspruch 5, wobei die Bewegung eine planetarische Rotationsbewegung des Substrats um sich selbst ist.

7. Vorrichtung nach Anspruch 5, wobei die Bewegung eine Rotations-Translationsbewegung des Substrats ist.

8. Vorrichtung nach Anspruch 7, wobei die Bewegung gewährleistet wird durch ein System ineinandergreifender Zahnräder, wobei sich zwei Zahnräder (95, 97) in derselben Ebene und um ein feststehendes Zahnrad (96) herum drehen.

9. Vorrichtung nach Anspruch 7, wobei die Bewegung durch ein Zahnrad (97) gewährleistet wird, das in einem konstanten Abstand von einem Zahnrad (96) gehalten wird, wobei ein Zahnriemen (105) oder eine Kette das feststehende Zahnrad (96) und das Zahnrad (97) umgibt.

10. Vorrichtung nach Anspruch 4, wobei die Einrichtungen zum Kanalisieren der durch jede Quelle entwickelten Dämpfe mit dieser Quelle eine Zelle abgrenzen, die durch das sich bewegende Substrat in dieser Zelle bestrichene Fläche in einer zur Aufdampfrichtung in dieser Zelle senkrechten Ebene ein Symmetriezentrum aufweist und die Quelle sich in einer Achse befindet, die zu der durch das Substrat bestrichenen Fläche senkrecht ist und dieses Symmetriezentrum durchläuft.

11. Beschichtungsverfahren durch Aufdampfen eines Materials auf ein Substrat, dadurch gekennzeichnet, daß man das Substrat in einen Behälter einer Vorrichtung nach einem der Ansprüche 1 bis 10 gibt und anschließend das Aufdampfen durchführt.

12. Verfahren nach Anspruch 11, wobei das Substrat ein Substrat für Mikrospitzen-Elektronenquellen ist.


**Claims**

1. Apparatus for depositing a material by evaporation on a substrate (69, 90, 112), characterized in that it comprises an enclosure (43, 62, 72) in which are placed n material evaporation sources (40, 42, 44, 46) and means (48-51, 64, 66, 68, 70, 74, 76, 78, 80) for piping the vapours emitted by said sources to the substrate, during evaporation, formed by walls or covers defining compartments within the enclosure, each evaporation source being located within a compartment.

2. Apparatus according to claim 1, the walls or covers being vertical.

3. Apparatus according to claim 1, the walls or covers forming cells having at least partly a truncated cone-shaped structure.

4. Apparatus according to one of the claims 1 to 3, also comprising means (94-100) for moving a substrate so as to pass different portions of the substrate successively in front of different sources.

5. Apparatus according to claim 4, the moving means being Deans for producing and/or combining rotary and/or translatory movements in one plane.

6. Apparatus according to claim 5, the movement being a planetary rotation movement of the substrate on itself.

7. Apparatus according to claim 5, the movement being a rotary-translatory movement of the substrate.

8. Apparatus according to claim 7, the movement being provided by a system having to nested gears (95, 97) rotating in the same plane and about a fixed sprocket (96).

9. Apparatus according to claim 7, the movement being provided by a gear (97) kept at a constant distance from a fixed sprocket (96), a toothed belt (105) or a chain surrounding the fixed sprocket (96) and the gear (97).

**10.** Apparatus according to claim 4, the means for piping the vapours emitted by each source defining, with said source, a cell, the surface swept by the substrate moving in said cell having, in a plane perpendicular to the evaporation direction in said cell, a centre of symmetry, the source being placed on an axis perpendicular to the surface swept by the substrate and passing through said centre of symmetry.

**11.** Process for the deposition by evaporation of a material on a substrate, characterized in that the substrate is introduced into an enclosure of an apparatus according to one of the claims 1 to 10 and in that evaporation then takes place.

**12.** Process according to claim 11, the substrate being for a micro-tip electron source.

FIG. 1

FIG. 2

FIG. 3

FIG. 4

FIG. 5A

FIG. 5B

FIG. 6A

FIG. 6B

FIG. 6C

FIG. 8 A

FIG. 8 B

FIG. 8C

FIG. 8D

FIG. 8 E

FIG. 7

FIG. 9

FIG. 10

FIG. 11

FIG. 12

FIG. 13

FIG. 14

FIG. 15

FIG. 16

FIG. 17

FIG. 18

FIG. 19

FIG. 20

24